# EUROPEAN PATENT APPLICATION

(11) **EP 4 822 992 A1**
(43) Date of publication of application: **14.10.2026**
(21) Application number: 25169645.6
(22) Date of filing: 10.04.2025
(51) Int. Cl.: H03K 17/95, G01D 11/24

(54) **COIL CORE, INDUCTIVE SENSOR, MEASUREMENT SYSTEM AND METHOD**

(71) Applicant: SICK AG, 79183 Waldkirch (DE)
(72) Inventor: Lai, Weng Yuen, 645517 Singapore (SG); Lee, Chee Huei, 750324 Singapore (SG); Hu, Dan, 128807 Singapore (SG); Tun, Myint, 752592 Singapore (SG)
(74) Representative: Manitz Finsterwald Patent- und Rechtsanwaltspartnerschaft mbB

(57) **Abstract**

In one embodiment a coil core for an inductive sensor comprises a base part having an inner wall which has a closed-loop cylindrical shape, an outer wall surrounding the inner wall and a ground portion extending perpendicularly from the inner wall towards a center of the base part. The ground portion is prepared for accommodating a coil. The outer wall of the base part comprises at least one flattened section, which is arranged in between two curved sections of the outer wall.

## Description

The present disclosure is directed to a coil core for an inductive sensor, an inductive sensor, a measurement system and a method for providing a measurement system.

Inductive sensors may be employed for detecting proximity of an object containing some metal material in a non-conducting way. Use of this kind of sensors has become widespread. In some applications it is necessary to use more than one inductive sensor in close proximity. In case a specified minimum distance, for example according to a data sheet of the employed sensor, the sensors mutually influence each other. Therein, one sensor is affected by magnetism or static capacitance from an adjacent sensor, which leads to an unstable output of both sensors.

A known solution to this problem entails using a different oscillation frequency for each adjacent sensor. In this way the interference can be mitigated.

However, the use of alternative or different oscillation frequencies on different sensors which are mounted next to each other, leads to two distinctive sensor devices with different part numbers with unwanted implications with respect to maintenance and installation.

Accordingly, an object of the present disclosure consists in finding a solution for reducing mutual interference in inductive sensing.

The object is achieved by the subject-matter of the independent patent claims. Embodiments and developments are defined by the dependent claims.

In one aspect, the present disclosure is directed at a coil core for an inductive sensor. The coil core comprises a base part having an inner wall, an outer wall and a ground portion. The inner wall has a closed-loop cylindrical shape. The outer wall surrounds the inner wall. The ground portion extends perpendicularly from the inner wall towards a center of the base part. The ground portion is prepared for accommodating a coil. The outer wall of the base part comprises at least one flattened section, which is arranged in between two curved sections of the outer wall.

By employing a cylindrically shaped closed-loop base part spreading of magnetic flux is greatly reduced. Thereby interference with another inductive sensor mounted in close proximity is concurrently reduced. This effect is combined with the special geometry of the outer wall of the base part, which has at least one section which is flat or straight. Thereby more space is created for the ground portion, which enables accommodation of a bigger coil, which may generate a stronger magnetic field together with the specified coil core. The resulting magnetic field propagates predominantly in a direction which is perpendicular to the ground portion of the base part. Thereby leakage of magnetic flux to the sides of the coil core which are oriented in parallel to the ground portion is avoided, leading to mitigation of mutual interference of closely mounted sensors having the claimed coil core.

The base part of the coil core can be seen as realizing a Petri dish shape. The closed loop inner wall is realized without any air gap. In other words, it is free from any slot. The cylindrical shape of the inner wall may be circular cylindrical. The ground portion may have a circular shape. A center of said circle represents the center of the base part. A height of the inner wall may be adapted to a height of the outer wall and is prepared such that a coil can be fully accommodated in the coil core when it resides on the ground portion.

The specified coil core, especially its base part, may be regarded as a hollow cylinder, which has at least one flattened section on its side representing the height of the geometrical cylindrical form.

In a development the outer wall of the base part comprises four flattened sections. These are arranged intermittently with four curved sections along the outer wall of the base part. The flattened sections are preferably arranged at approximately every 90° around the center of the base part.

In this development the outer wall is formed by curved sections and flattened sections which are arranged in turns. Each curved section has approximately the form of a segment of an imaginary or theoretical circle. Said circle may represent a cross-section of the base part of the coil core performed in a direction parallel to the ground portion. In this development said cross-section shows four flattened sections which are alternated with four curved sections, each of which may take the form of a circular segment. In one implementation the flattened sections are positioned at roughly every 90° around the center of the base part which may be the center of the imaginary circle. Said center of the base part also represents the cylinder axis of the hollow cylinder.

In a development the coil core further comprises a center part, which projects perpendicularly from the ground portion of the base part. The center part has a central opening, which is arranged at the center of the base part.

The center part on the one side and the inner wall on the other side limit a recess within the coil core, the bottom of which coincides with the ground portion. When a coil is mounted to the coil core, it resides in said recess and encloses the center part. The central opening is positioned at the center of the base part, which coincides with the cylinder axis of the hollow cylinder with one or more flattened sides of the base part.

In a development a cross-sectional shape of an inner side of the central opening is non-circular and is prepared for mounting a plastic cover and/or an evaluation circuit to the coil core.

The cross-section thereby is performed perpendicular to the central opening. The special form of the central opening, which is non-circular, prevents wrong positioning of the coil core, when a plastic cover, which encapsulates the coil core as known to the skilled reader, is placed on the coil core. Alternatively or additionally, an evaluation circuit may be mounted to the coil core at the central opening. A connecting part of the plastic cover and/or a connecting part of the evaluation circuit has/each have a cross-sectional shape corresponding to the cross-sectional shape of the inner side of the central opening. As the plastic cover's and/or evaluation circuit's connecting part and the central opening have matching shapes, wrong positioning is prohibited in the sense of a so-called Poka Yoke process. In other words, fail safe mounting of the coil core is supported in this way. This means that the plastic cover and/or evaluation circuit and the coil core may be mounted in a sort of plug socket manner.

In a development the ground portion comprises a first feed through for accommodating at least one coil connection wire. The first feedthrough may be arranged non-centrally.

Accordingly, the ground portion has at least one hole or passageway or passage, i.e. the first feedthrough. Through this hole one or two wires connecting a coil installed in the coil core to an evaluation circuit, for example, are threaded. The first feedthrough can be placed in a non-central position within the ground portion. In other words, it may be arranged biaxially.

In a further development the coil core comprises a second feedthrough, which may also be arranged non-centrally. The second feedthrough may be arranged in relation to the first feedthrough on an opposite side of the center of the base part and is prepared for accommodating another coil connection wire.

In this development the coil core has two feedthroughs or holes perforating the ground portion of the base part, so that depending on a realization of the coil to be installed in the coil core one wire may be passed through the first feedthrough and the second wire can be connected via the second feedthrough to an evaluation circuit. Also, the second feedthrough is placed outside the center of the base part. First and second feedthroughs are preferably positioned on opposite sides of the center.

According to a development the coil core comprises ferrite or is made of ferrite.

The coil core may consequently be referred to as a ferrite core. In alternative implementations other materials may be used for the coil core, for instance iron powder, amorphous metals or nanocrystalline materials. Thereby, the coil core can be employed for realizing an inductive sensor.

Another aspect of the present disclosure concerns an inductive sensor comprising a housing, at least one coil core according to the embodiments and developments described above, a coil and an evaluation circuit. The housing preferably has a rectangular shape. The at least one coil core is arranged in the housing. The coil is mounted to the ground portion of the coil core. The evaluation circuit is arranged in the housing and electrically connected to the coil. The evaluation circuit is also connected mechanically to the coil core.

Using the above specified coil core, the inductive sensor is realized by inserting the coil to the coil core, mechanically attaching and electrically connecting the evaluation circuit and arranging the resulting entity in the housing. The coil core together with the coil mounted realize an inductor, which when operated by the evaluation circuit represents a resonance circuit. As described above, the coil core's sidewall represented by the outer wall has at least one, preferably four, flattened or straight sections, which are each arranged in between two curved sections. The closed loop ferrite core of this shape enables the resulting inductive sensor to generate a magnetic field which is directed towards the intended target, but is prohibited from unwanted propagation to an adjacent sensor. The space for accommodating the coil is wider, when compared to a state-of-the-art coil core which has an all rounded or completely circular form. The coil can be realized with a comparably big form factor, resulting in a stronger magnetic field in the intended direction, which is the front of the sensor, i.e. perpendicular to the ground section. The specified coil core being inserted in the housing of rectangular shape may have an equator diameter on its inner wall compared with a state of the art all rounded coil core which is inserted in a housing of rectangular shape. Unwanted leaking of the magnetic flux to neighboring inductive sensors is prohibited, while the wanted function of the sensor is still perfectly well realized.

According to established practice, the evaluation circuit performs processing of the signals generated by the coil core with coil combination, which allows the sensor to accurately detect and measure the presence and distance of metallic objects in its vicinity. In particular, the evaluation circuit may detect changes in the oscillator signal caused by the presence of a metallic object. When a metal object enters the sensor's electromagnetic field, it induces eddy currents that alter the signal. Furthermore, the circuit may convert these changes into a usable output signal. For digital sensors, this means generating a switching signal when a threshold is reached. For analog sensors, it involves producing a continuous signal proportional to the distance of the object. Finally, said converted signal may then be amplified to ensure it is strong enough for further processing or transmission to other devices.

The evaluation circuits can be realized in the form of a printed circuit board, PCB. With the proposed inductive sensor in which the coil core has one or two feedthroughs for the coil wires the coil location can be chosen to be at the same axis on the coil core, such that contacts of the coil wire can be soldered to a same side or to opposite sides of the evaluation circuit's PCB.

In a development the inductive sensor further comprises a shield which is arranged around the outer wall of the coil core. A shape of the shield is adapted to the shape of the outer wall of the coil core.

The shield is mounted adjacent to the outer wall, thereby surrounding the coil core. As its shape conforms to the shape of the outer wall of the coil core, the shield just the same has at least one, preferably four flattened sections, which are arranged in turn with curved sections. The shape of the shield adds to the fail-safe mounting of the coil core inside the housing according to the Poka Yoke concept.

In a development the shield comprises metal or is made from metal.

The metal shield is employed to further minimize leakage of magnetic flux of the inductive sensor to adjacent sensors.

Another aspect of the present disclosure relates to a measurement system. Said system comprises at least two inductive sensors, each being realized according to one of the embodiments described above. The inductive sensors are operated with approximately the same oscillation frequency. The inductive sensors are arranged side by side at a distance shorter than one diameter of the sensor's housing, in particular at a distance shorter than one diameter of an active surface of the sensor, in case of a flush mounting of each sensor. Alternatively, in case of a non-flush mounting of each sensor, the inductive sensors are arranged side by side at a distance shorter than two times said diameter, in particular shorter than two times the diameter of the active surface of the sensor.

As known to those skilled in the art, flush mounting, which is also referred to as embeddable mounting, means that the sensor, especially its active surface, is flush with the mounting surface. In contrast to this, a sensor in a non-flush mounting extends out from the mounting surface or bracket. Depending on the kind of mounting, state-of-the-art inductive sensors require certain minimum distances between adjacent sensors due to mutual interference of the respectively generated magnetic fields. In this, traditional sensors mounted according to the flush way require a shorter minimum distance than those mounted according to the non-flush way. Usually, flush mounting requires a distance of one diameter of the sensors housing, particularly of its active surface, while non-flush mounting requires at least two times said diameter.

With the coil core as specified and described above it is possible to place two inductive sensors adjacent to each other, for instance in a line or face to face, closer than the normally required minimum distance. The sensors can be operated with about the same oscillation frequency, thereby simplifying installation and maintenance.

A further aspect of the present disclosure concerns a method for providing a measurement system. The method comprises
mounting a first inductive sensor according to the embodiments and developments described above,
mounting a second inductive sensor according to the embodiments described above in proximity to the first inductive sensor,
operating the first and the second sensor with approximately the same oscillation frequency,
wherein a distance between the first and second sensor is shorter than one diameter of the sensor's housing, in particular shorter than one diameter of an active surface of the sensor, in case of a flush mounting of the sensor, or wherein the inductive sensors are arranged side by side at a distance shorter than two times said diameter in case of a non-flush mounting of each sensor.

By means of the proposed method two or more inductive sensors can be mounted close together to form the measurement system. Due to the inventive concept, the distance between the sensors can be shorter than the normally required one or two diameters depending on flush or non-flush mounting even though the sensors are running on the about same oscillation frequency.

In all other aspects, the statements made above concerning the coil core and the inductive sensor apply accordingly to the measurement system and the method, in particular with respect to advantages and embodiments or developments. The mentioned embodiments and developments can be combined with each other, unless explicitly stated otherwise.

Exemplary embodiments and functions of the present disclosure are described herein in conjunction with the following drawings, in which like reference numbers refer to like parts and which show schematically in:
- Fig. 1A and 1B: a first exemplary realization of the coil core as proposed,
- Fig. 2A and 2B: a second exemplary realization of the coil core as proposed,
- Figs. 3A - 3D: different perspective views of a third exemplary embodiment of the proposed coil core,
- Fig. 4A and 4B: an exemplary embodiment of the inductive sensor as proposed,
- Fig. 5: an exemplary realization of the shield as proposed, and
- Fig. 6a and 6b: an exemplary realization of the housing as proposed.

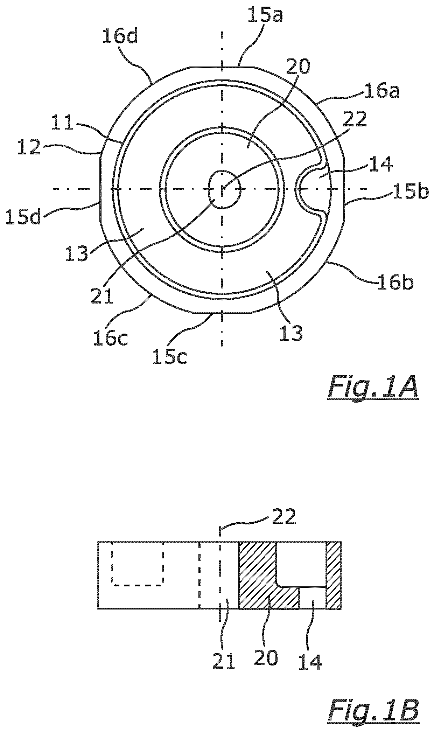

Figs. 1A and 1B show a first exemplary embodiment of the coil core as proposed. Fig. 1A shows a cross-sectional view of the coil core, cross-section being performed perpendicular to the central opening 21, which coincides with a cross-section performed in parallel to the ground portion 13. The inner wall 11 of the base part has the closed loop cylindrical shape, while the outer wall 12 in this example has four flattened sections 15a, 15b, 15c, 15d and four curved sections 16a, 16b, 16c, 16d, which are arranged in an alternating fashion. The center part 20 has the central opening 21 arranged at the center of the coil core. In this example the central opening 21 has a non-circular shape. The outer wall 12 surrounds the central opening 21. It can also be seen that in this example the ground portion 13 has just one feedthrough 14 arranged outside the axis 22 adjacent to the inner wall 11.

Fig. 1B shows the first exemplary embodiment in another cross-sectional view. In this case the cross-section has been performed perpendicular to the ground portion 13 of the coil core.

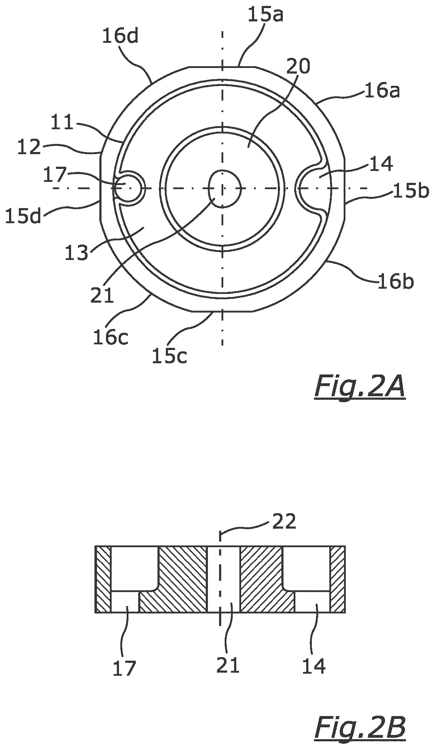

Figs. 2A and 2B show a second exemplary embodiment of a coil core as proposed. Fig. 2A presents a cross-sectional view which is comparable to the cross-sectional view of Fig. 1a. In contrast to the first embodiment the second exemplary embodiment depicted in Fig. 2A has a second feedthrough 17 which is placed in this example on the opposite side of the center 22 with relation to the first feedthrough 14.

Fig. 2B shows another cross-sectional view of the second exemplary embodiment which is comparable to the representation of Fig. 1B.

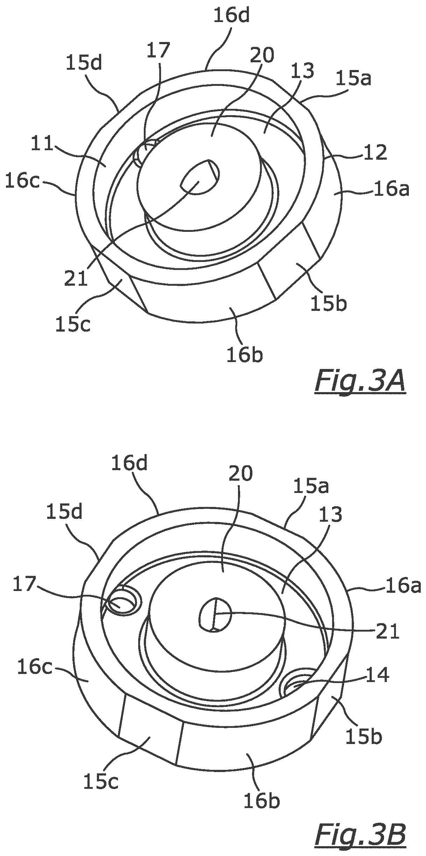

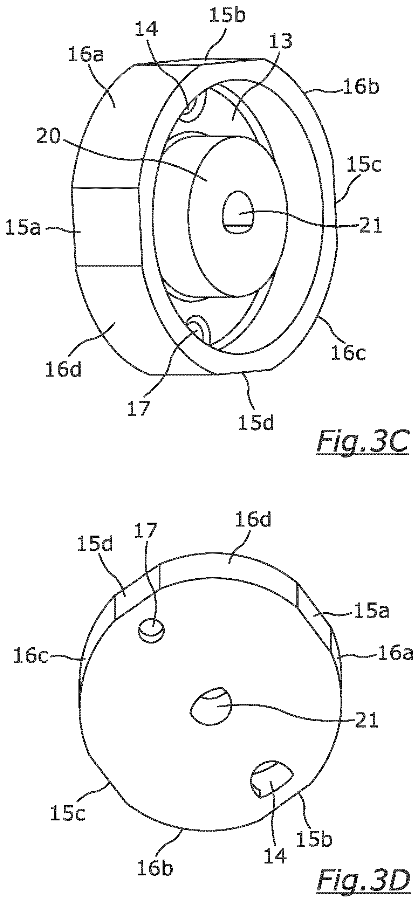

Figs. 3A to 3D each show a perspective view of a third exemplary embodiment of the coil core as proposed. A 3D model of the second exemplary embodiment of Fig. 2A and 2B is depicted, wherein the base part 10 can be decerned in relation to the center part 20.

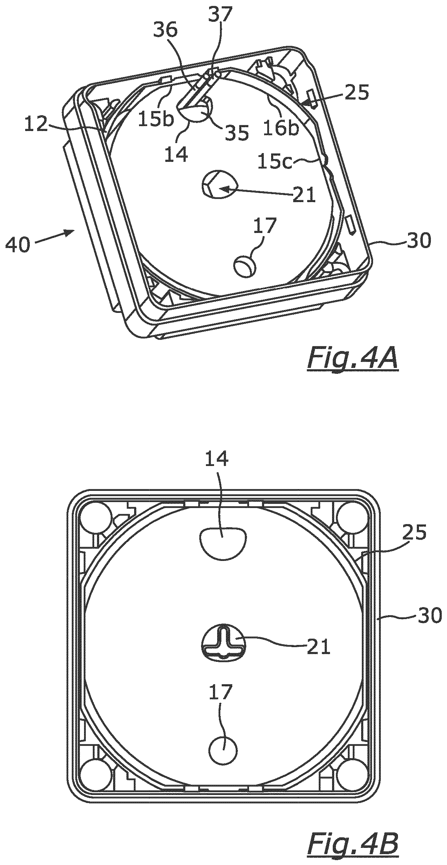

Figs. 4A and 4B show an exemplary embodiment of the inductive sensor as proposed. Fig. 4A shows a 3D view of the sensor from the bottom side, i.e. from below the ground portion. The coil core used in this embodiment example coincides with the coil core embodiment example of Fig. 2A and B which has first a second feedthroughs 14, 17. The coil 35 has been mounted to the coil core and can be discerned through first and second feedthroughs 14, 17. Also, shield 25 is arranged around the outer wall 12 of the coil core with its shape being adjusted to the shape of the outer wall 12. Coil connection wires 36, 37 extend through the first feedthrough 14. The sensor is mounted in the housing 30, which has rectangular shape. Active surface 40 is indicated on the other side. The non-circular shape of the central opening 21, which enables fail safe connection with an evaluation circuit, can be discerned, as well.

Fig. 4B shows the inductive sensor of Fig. 4A in a view from the bottom of the coil core. In this view, the coil is not shown.

With the flat surfaces 15a to 15d at four sides of the coil core arranged in the rectangular housing 30, the coil core can have a bigger diameter to accommodate a bigger coil.

Figure 5 shows an exemplary realization of the shield 25 as proposed. The widest section 26 of the shield 25 is arranged in the embodiments of Fig. 4A and 4B adjacent to first feedthrough 14 in order to provide good shielding for the coil connection wires 36, 37 extending through the first feedthrough 14.

Figs. 6a and 6b show an exemplary realization of the housing 30 as proposed in a 3D and a 2D view.

Due to the closed loop ferrite coil core, less magnetic field is being propagated sideways by the proposed solution. According to the solution more space is created in the coil core to accommodate a bigger coil, which enables generation of a stronger magnetic field propagating towards the intended direction or target. Leaking sideways magnetic flux, which would cause interference, is largely prohibited.

According to the proposed solution there is no constraint on how to assemble the PCB, coil core and housing. For example, a spring feature housing can be employed to press on the coil core, using direct soldering to the PCB or using glue.

It is to be understood that the embodiments explained above show the principle of the present application only for the purpose of illustration. In practice, embodiments may be realized in many different applications/use cases employing different values of components. The term comprising refers to a non-exhaustive list of components.

### Reference list

- 11, 12: wall
- 13: ground portion
- 14, 17: feedthrough
- 15a, ..., 15d: flattened section
- 16a, ..., 16d: curved section
- 20: center part
- 21: central opening
- 22: axis
- 25: shield
- 26: section
- 30: housing
- 35: coil
- 36, 37: coil connection wire

## Claims

1. Coil core for an inductive sensor,
comprising a base part having an inner wall (11) which has a closed-loop cylindrical shape, an outer wall (12) surrounding the inner wall and a ground portion (13) extending perpendicularly from the inner wall towards a center of the base part,
wherein the ground portion (13) is prepared for accommodating a coil, and wherein the outer wall (12) of the base part comprises at least one flattened section (15a), which is arranged in between two curved sections (16a, 16b) of the outer wall (12).

2. Coil core according to claim 1,
wherein the outer wall (12) of the base part comprises four flattened sections (15a, 15b, 15c, 15d), which are arranged intermittently with four curved sections (16a, 16b, 16c, 16d) along the outer wall (12) of the base part, wherein the flattened sections are preferably arranged at approximately every 90 degree around the center of the base part.

3. Coil core according to claim 1 or 2,
further comprising a center part (20) projecting perpendicularly from the ground portion (13) of the base part and having a central opening (21) arranged at the center of the base part.

4. Coil core according to the preceding claim,
wherein a cross-sectional shape of an inner side of the central opening (21) is non-circular and is prepared for mounting a plastic cover and/or an evaluation circuit to the coil core.

5. Coil core according to any of claims 1 to 4,
wherein the ground portion (13) comprises a first feedthrough (14) for accommodating at least one coil connection wire (36, 37), wherein the first feedthrough (14) may be arranged non-centrally.

6. Coil core according to the preceding claim,
further comprising a second feedthrough (17), which may be non-centrally arranged and which may be arranged in relation to the first feedthrough (14) on an opposite side of the center of the base part,
wherein the second feedthrough (17) is prepared for accommodating another coil connection wire.

7. Coil core according to any of claims 1 to 6,
wherein the coil core comprises ferrite or is made of ferrite.

8. Inductive sensor comprising
a housing (30), which is preferably of rectangular shape,
a coil core according to any of claims 1 to 7, which is arranged in the housing (30),
a coil (35) mounted to the ground portion (13) of the coil core,
an evaluation circuit arranged in the housing (30) and electrically connected to the coil (35),
wherein the evaluation circuit is mechanically connected to the coil core.

9. Inductive sensor according to the preceding claim
further comprising a shield (25) arranged around the outer wall (12) of the coil core, wherein a shape of the shield (25) is adapted to the shape of the outer wall (12) of the coil core.

10. Inductive sensor according to the preceding claim,
wherein the shield (25) comprises metal.

11. Measurement system comprising at least two inductive sensors, each according to any of claims 8 to 10,
wherein the inductive sensors are operated with approximately the same oscillation frequency,
wherein the inductive sensors are arranged side by side at a distance shorter than one diameter of the sensor's housing, in particular one diameter of an active surface (40) of the sensor, in case of a flush mounting of each sensor,
or
wherein the inductive sensors are arranged side by side at a distance shorter than two times said diameter in case of a non-flush mounting of each sensor.

12. Method for providing a measurement system comprising
Mounting a first inductive sensor according to any of claims 8 to 10,
Mounting a second inductive sensor according to any of claims 8 to 10 in proximity to the first inductive sensor,
Operating the first and the second sensor with approximately the same oscillation frequency,
wherein a distance between the first and the second sensor is shorter than one diameter of the sensor's housing, in particular one diameter of an active surface (40) of the sensor, in case of a flush mounting of each sensor, or
wherein the inductive sensors are arranged side by side at a distance shorter than two times said diameter in case of a non-flush mounting of each sensor.

## Amended claims

### Amended claims in accordance with Rule 137(2) EPC.

1. Coil core for an inductive sensor,
comprising a base part having an inner wall (11) which has a closed-loop cylindrical shape, an outer wall (12) surrounding the inner wall and a ground portion (13) extending perpendicularly from the inner wall towards a center of the base part,
wherein the ground portion (13) is prepared for accommodating a coil, the coil core being **characterized in that** the outer wall (12) of the base part comprises at least one flattened section (15a), which is arranged in between two curved sections (16a, 16b) of the outer wall (12).

2. Coil core according to claim 1,
wherein the outer wall (12) of the base part comprises four flattened sections (15a, 15b, 15c, 15d), which are arranged intermittently with four curved sections (16a, 16b, 16c, 16d) along the outer wall (12) of the base part, wherein the flattened sections are preferably arranged at approximately every 90 degree around the center of the base part.

3. Coil core according to claim 1 or 2,
further comprising a center part (20) projecting perpendicularly from the ground portion (13) of the base part and having a central opening (21) arranged at the center of the base part.

4. Coil core according to the preceding claim,
wherein a cross-sectional shape of an inner side of the central opening (21) is non-circular and is prepared for mounting a plastic cover and/or an evaluation circuit to the coil core, wherein the cross-section is performed perpendicular to the central opening (21).

5. Coil core according to any of claims 1 to 4,
wherein the ground portion (13) comprises a first feedthrough (14) for accommodating at least one coil connection wire (36, 37), wherein the first feedthrough (14) may be arranged non-centrally within the ground portion (13).

6. Coil core according to the preceding claim,
further comprising a second feedthrough (17), which may be non-centrally arranged and which may be arranged in relation to the first feedthrough (14) on an opposite side of the center of the base part,
wherein the second feedthrough (17) is prepared for accommodating another coil connection wire.

7. Coil core according to any of claims 1 to 6,
wherein the coil core comprises ferrite or is made of ferrite.

8. Inductive sensor comprising
a housing (30), which is preferably of rectangular shape,
a coil core according to any of claims 1 to 7, which is arranged in the housing (30),
a coil (35) mounted to the ground portion (13) of the coil core,
an evaluation circuit arranged in the housing (30) and electrically connected to the coil (35),
wherein the evaluation circuit is mechanically connected to the coil core.

9. Inductive sensor according to the preceding claim further comprising a shield (25) arranged around the outer wall (12) of the coil core, wherein a shape of the shield (25) is adapted to the shape of the outer wall (12) of the coil core.

10. Inductive sensor according to the preceding claim,
wherein the shield (25) comprises metal.

11. Measurement system comprising at least two inductive sensors, each according to any of claims 8 to 10,
wherein the inductive sensors are operated with approximately the same oscillation frequency,
wherein the inductive sensors are arranged side by side at a distance shorter than one diameter of the sensor's housing, in particular one diameter of an active surface (40) of the sensor, in case of a flush mounting of each sensor,
or
wherein the inductive sensors are arranged side by side at a distance shorter than two times said diameter in case of a non-flush mounting of each sensor.

12. Method for providing a measurement system comprising Mounting a first inductive sensor according to any of claims 8 to 10, Mounting a second inductive sensor according to any of claims 8 to 10 in proximity to the first inductive sensor,
Operating the first and the second sensor with approximately the same oscillation frequency,
wherein a distance between the first and the second sensor is shorter than one diameter of the sensor's housing, in particular one diameter of an active surface (40) of the sensor, in case of a flush mounting of each sensor, or wherein the inductive sensors are arranged side by side at a distance shorter than two times said diameter in case of a non-flush mounting of each sensor.
